# EUROPEAN PATENT SPECIFICATION

(11) **EP 4 386 407 B1**
(45) Date of publication and mention of the grant of the patent: **20.11.2024**
(21) Application number: 23155278.7
(22) Date of filing: 07.02.2023
(51) Int. Cl.: G01R 31/64, G01R 27/26, G01R 31/40

(54) **POWER SUPPLY, CALCULATION CIRCUIT AND CAPACITOR AGING DETECTION METHOD THEREOF**
STROMVERSORGUNG, BERECHNUNGSSCHALTUNG UND VERFAHREN ZUR ERKENNUNG DER ALTERUNG EINES KONDENSATORS DAFÜR
ALIMENTATION ÉLECTRIQUE, CIRCUIT DE CALCUL ET PROCÉDÉ DE DÉTECTION DE VIEILLISSEMENT DE CONDENSATEUR ASSOCIÉ

(30) Priority: 15.12.2022 TW 111148133
(43) Date of publication of application: 19.06.2024
(73) Proprietor: Moxa Inc., New Taipei City 242 (TW)
(72) Inventor: CHEN, Yi-Fu, 242 New Taipei City (TW); TING, Jui-Lin, 242 New Taipei City (TW)
(74) Representative: Kurig, Thomas

(56) References cited:
- US-B1- 10 534 029

## Description

### Background

### Technical Field

The disclosure relates to a power circuit, and in particular relates to a power supply, a calculation circuit, and a capacitor aging detection method thereof.

### Description of Related Art

The performance of a power supply usually gradually declines after being used for a time duration. The most common degradation behaviors include poorer efficiency, reduced hold-up time, larger voltage ripple, etc. The most important reason for the performance degradation of the power supply is often related to the aging of the capacitors in the power supply (capacitance attenuation). Generally speaking, users do not know the aging condition of the capacitors in the power supply. Users often replace the power supply only after the function of the power supply is completely lost. However, the operation of the power supply has already gone through a long period of performance degradation before the function of the power supply is completely lost, so that the user has to pay more additional energy costs. If the user may know about the current capacitor aging information of the power supply in real time, the user may use the aging information to evaluate whether to replace the power supply preventively, so as to avoid unnecessary energy waste and equipment abnormalities.
US 10 534 029 B1 discloses a power conversion apparatus including a primary-side circuit, a bulk capacitor, a conversion circuit, and a master control circuit. The primary-side circuit is adapted to rectify and boost an alternating-current power and output primary-side output. The bulk capacitor is connected in parallel to two output ends of the primary-side output. The conversion circuit is configured to receive the primary-side output passing through the bulk capacitor and convert the primary-side output into secondary-side output. The master control circuit detects an electric power state of the alternating-current power, obtains a time interval, a power of the secondary-side output corresponding to the time interval, and two of the capacitor voltages corresponding to the start and the end of the time interval when the electric power state is power-off, and selectively outputs an abnormal signal according to the time interval, the power, the capacitor voltages, and a threshold.

### Summary

The present invention is provided in the appended claims. More specifically, the invention provides calculation circuits according to claims 1 and 14, power supplies according to claims 7 and 16, and methods according to claims 9 and 18.

The following disclosure serves a better understanding of the present invention. The disclosure provides a power supply, a calculation circuit, and a capacitor aging detection method thereof, so as to generate information about current capacitor aging in real time.

In an embodiment of the disclosure, the calculation circuit includes an output current detection circuit, an output voltage detection circuit, and a processor. The output current detection circuit is coupled to a power conversion circuit to detect an output current of the power conversion circuit. The output voltage detection circuit is coupled to the power conversion circuit to detect an output capacitor voltage of an output capacitor of the power conversion circuit. The processor is coupled to the output current detection circuit and the output voltage detection circuit. The processor uses the output current and the output capacitor voltage to calculate output power of the power conversion circuit. The processor uses the output capacitor voltage, the output power, and first time information to calculate the current output capacitor value of the power conversion circuit, and triggers a notification based on the current output capacitor value.

In an embodiment of the disclosure, the power supply includes the power conversion circuit and the calculation circuit. The power conversion circuit is used to convert an input voltage into an output voltage to obtain output power. The calculation circuit is coupled to the power conversion circuit to measure a capacitor voltage, output power, and time information of the power conversion circuit. The calculation circuit uses the capacitor voltage, the output power, and the time information to calculate a current capacitor value of the power conversion circuit, and triggers a notification based on the current capacitor value.

In an embodiment of the disclosure, the above-mentioned capacitor aging detection method includes the following operation. A capacitor voltage, output power, and time information of the power conversion circuit is measured. The power conversion circuit is used to convert an input voltage into an output voltage to obtain output power. The capacitor voltage, the output power, and the time information are used to calculate a current capacitor value of the power conversion circuit. A notification is triggered based on the current capacitor value.

In an embodiment of the disclosure, the calculation circuit includes an input voltage detection circuit, an output voltage detection circuit, and a processor. An input voltage detection circuit is coupled to the power conversion circuit to detect an input capacitor voltage of the power conversion circuit. An output voltage detection circuit is coupled to the power conversion circuit to detect an output capacitor voltage of the power conversion circuit. The processor is coupled to the input voltage detection circuit and the output voltage detection circuit. The processor uses the input capacitor voltage and the output capacitor voltage to calculate current hold-up time. The processor triggers a notification based on the current hold-up time.

In an embodiment of the disclosure, the power supply includes the power conversion circuit and the calculation circuit. The power conversion circuit is used to convert an input voltage into an output voltage to obtain output power. The calculation circuit is coupled to the power conversion circuit and used to measure the input capacitor voltage and the output capacitor voltage of the power conversion circuit. The calculation circuit uses the input capacitor voltage and the output capacitor voltage to calculate the current hold-up time of the power conversion circuit, and triggers a notification based on the current hold-up time.

In an embodiment of the disclosure, the capacitor aging detection method includes the following operation. An input capacitor voltage and an output capacitor voltage of the power conversion circuit is measured. The input capacitor voltage and output capacitor voltage are used to calculate a current hold-up time of the power conversion circuit. A notification is triggered based on the current hold-up time.

Based on the above, the power supply according to the embodiments of the disclosure may generate information about capacitor aging (such as the current capacitor value or the current hold-up time of the power conversion circuit) in real time. In some embodiments, the calculation circuit may notify/provide the current capacitor aging information to the system circuit outside the power supply, so the user may refer to the capacitor aging information to decide whether to replace the power supply. In other embodiments, the calculation circuit may decide whether to send a warning based on the information about the current capacitor aging (notify/provide the capacitor aging warning to the system circuit outside the power supply), thereby the system circuit notifies the user to replace the power supply. According to the invention, in each embodiment, a step down in the voltage of an input capacitor is detected to determine that power-off to a power conversion circuit occurs, and it is further detected that an input current flowing via a power switch to the input capacitor turns to zero to determine that power-off occurs due to the switch being turned off.

Therefore, users may self-assess whether to replace the power supply preventively based on the information about the current capacitor aging, so as to avoid unnecessary energy waste and equipment abnormalities.

In order to make the above-mentioned features and advantages of the disclosure comprehensible, embodiments accompanied with drawings are described in detail below.

### BRIEF DESCRIPTION OF THE DRAWINGS

FIG. 1 is a circuit block schematic diagram of a power supply according to an embodiment of the disclosure.
FIG. 2 is a schematic flowchart of a capacitor aging detection method according to an embodiment of the disclosure.
FIG. 3 is a circuit block schematic diagram of a power conversion circuit and a calculation circuit according to an embodiment of the disclosure.
FIG. 4 is a waveform schematic diagram of an input current, an input capacitor voltage, and an output capacitor voltage according to an embodiment of the disclosure.
FIG. 5 is a schematic flowchart of a capacitor aging detection method according to another embodiment of the disclosure.
FIG. 6 is a waveform schematic diagram of an input current, an input capacitor voltage, and an output capacitor voltage according to an embodiment of the disclosure.
FIG. 7 is a schematic flowchart of a capacitor aging detection method according to yet another embodiment of the disclosure.

### DETAILED DESCRIPTION OF DISCLOSED EMBODIMENTS

The term "coupled (or connected)" as used throughout this specification (including the scope of the application) may refer to any direct or indirect means of connection. For example, if it is described in the specification that a first device is coupled (or connected) to a second device, it should be construed that the first device may be directly connected to the second device, or the first device may be indirectly connected to the second device through another device or some type of connecting means. Terms "first," "second" and the like mentioned in the full text (including the scope of the patent application) of the description of this application are used only to name the elements or to distinguish different embodiments or scopes and are not intended to limit the upper or lower limit of the number of the elements, nor is it intended to limit the order of the elements. In addition, wherever possible, elements/components/steps with the same reference numerals in the drawings and embodiments represent the same or similar parts. Elements/components/steps that use the same reference numerals or use the same terminology in different embodiments may refer to relevant descriptions of each other.

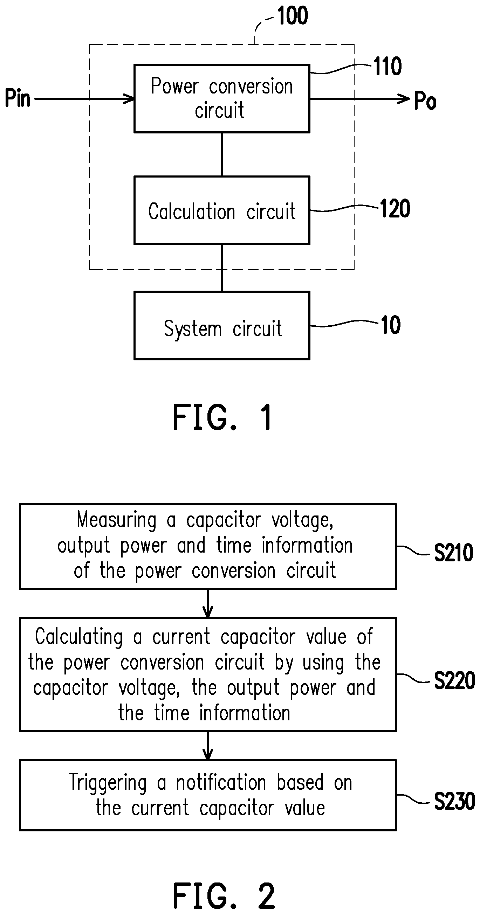

FIG. 1 is a circuit block schematic diagram of a power supply 100 according to an embodiment of the disclosure. The power supply 100 shown in FIG. 1 includes a power conversion circuit 110 and a calculation circuit 120. The power conversion circuit 110 may convert the input voltage V_{IN} (input power Pin) into an output voltage to obtain an output power Po, in order to supply power to other circuits (e.g., the system circuit 10 shown in FIG. 1). The calculation circuit 120 is coupled to the power conversion circuit 110. The calculation circuit 120 may monitor the electrical characteristics of the power conversion circuit 110 to generate current aging information (e.g., current capacitor value and/or current hold-up time) about the capacitance of the power conversion circuit 110 in real time. In some embodiments, the calculation circuit 120 may notify/provide the information about the current capacitor aging to the system circuit 10 outside the power supply 100, so the user may refer to the capacitor aging information to decide whether to replace the power supply 100. In other embodiments, the calculation circuit 120 may decide whether to send a warning based on the information about the current capacitor aging (notify/provide the capacitor aging warning to the system circuit 10 outside the power supply 100), thereby the system circuit 10 notifies the user to replace the power supply 100. Therefore, users may self-assess whether to replace the power supply 100 preventively based on the information about the current capacitor aging, so as to avoid unnecessary energy waste and equipment abnormalities.

FIG. 2 is a schematic flowchart of a capacitor aging detection method according to an embodiment of the disclosure. Referring to FIG. 1 and FIG. 2, in step S210, the calculation circuit 120 may measure the capacitor voltage, the output power Po, and the time information of the power conversion circuit 110. The specific measurement examples of the capacitor voltage and the output power Po are described below. It should be emphasized that the specific measurement methods of the capacitor voltage and the output power Po are not limited to the following content.

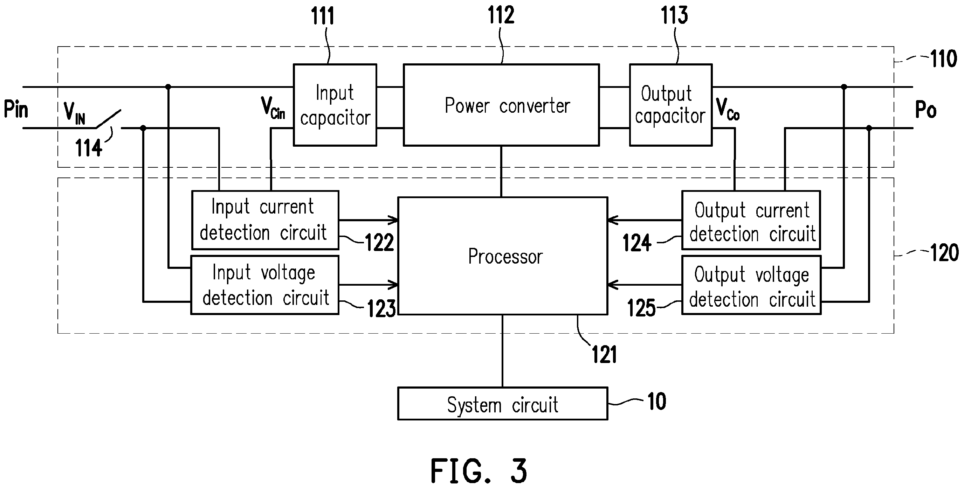

FIG. 3 is a circuit block schematic diagram of a power conversion circuit 110 and a calculation circuit 120 according to an embodiment of the disclosure. For the power conversion circuit 110 and the calculation circuit 120 shown in FIG. 3, reference may be made to the relevant descriptions of the power conversion circuit 110 and the calculation circuit 120 shown in FIG. 1, so details are not repeated herein. In the embodiment shown in FIG. 3, the power conversion circuit 110 includes an input capacitor 111, a power converter 112, and an output capacitor 113. The input capacitor 111 receives the input voltage V_{IN} through the power switch 114, in which the power switch 114 is controlled by the processor 121 of the calculation circuit 120. Here, the voltage of the input capacitor 111 is referred to as an input capacitor voltage Vein, and the voltage of the output capacitor 113 is referred to as an output capacitor voltage V_{Co}. When the power switch 114 is turned on, the input capacitor voltage V_{Cin} of the input capacitor 111 is equal to the input voltage V_{IN}. When the power switch 114 is turned off, the input capacitor voltage V_{Cin} steps down in response to the input voltage V_{IN} being powered off.

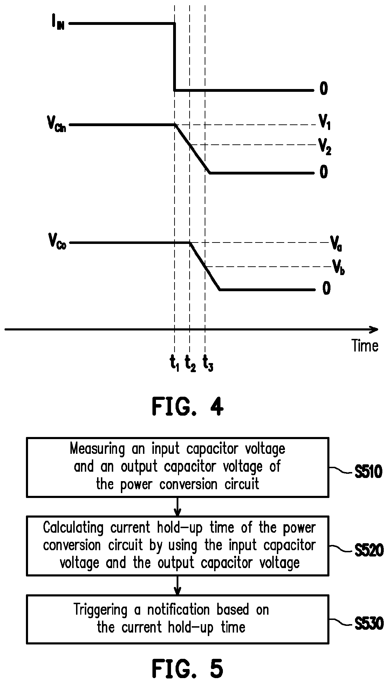

FIG. 4 is a waveform schematic diagram of an input current I_{IN}, an input capacitor voltage V_{Cin}, and an output capacitor voltage V_{Co} according to an embodiment of the disclosure. The horizontal axis shown in FIG. 4 represents time, and the vertical axis respectively represents current (corresponding to input current I_{IN}) and voltage (corresponding to input capacitor voltage V_{Cin} and output capacitor voltage V_{Co}). Referring to FIG. 3 and FIG. 4, when it is detected that the input current I_{IN} is 0, it is determined that a power-off occurs. Further, when the voltage detection circuit detects that the input voltage V_{IN} drops to the step-down threshold, it is determined that the power-off occurs. The input current I_{IN} (input voltage V_{IN}) is powered off at time point t₁. According to actual application scenarios, the "input current I_{IN} (input voltage V_{IN}) is powered off" may include that the power source (not shown) of the power supply 100 stops providing the input power Pin, and/or the power switch 114 is turned off. When the power switch 114 is turned off, or when the power source stops providing the input power Pin, the input capacitor voltage V_{Cin} and the output capacitor voltage V_{Co} of the power conversion circuit 110 are stepped down in response to the input current I_{IN} (input voltage V_{IN}) being powered off, as shown in FIG. 4.

The power converter 112 is coupled between the input capacitor V_{IN} and the output capacitor 113. The power converter 112 may convert the input capacitor voltage V_{Cin} into the output capacitor voltage V_{Co} for the output capacitor 113. The performance degradation of the power conversion circuit 110 is often related to the aging (capacitance attenuation) of the input capacitor 111 and/or the output capacitor 113. Based on actual design and application, the capacitor voltage in step S210 includes at least one of the input capacitor voltage V_{Cin} and the output capacitor voltage V_{Co}. Based on this, the calculation circuit 120 may generate capacitor aging information (such as the current capacitor value of the input capacitor 111 and/or the output capacitor 113) in real time.

In the embodiment shown in FIG. 3, the calculation circuit 120 includes a processor 121, an input current detection circuit 122, an input voltage detection circuit 123, an output current detection circuit 124, and an output voltage detection circuit 125. The input current detection circuit 122 is coupled to the power conversion circuit 110 to detect an input current of the power conversion circuit 110. The input voltage detection circuit 123 is coupled to the power conversion circuit 110 to detect an input capacitor voltage V_{Cin} of the input capacitor 111 of the power conversion circuit 110. The output current detection circuit 124 is coupled to the power conversion circuit 110 to detect an output current of the power conversion circuit 110. The output voltage detection circuit 125 is coupled to the power conversion circuit 110 to detect an output capacitor voltage V_{Co} of the output capacitor 113 of the power conversion circuit 110. The processor 121 is coupled to the input current detection circuit 122, the input voltage detection circuit 123, the output current detection circuit 124, and the output voltage detection circuit 125. Therefore, the processor 121 may measure the capacitor voltage (the input capacitor voltage V_{Cin} and/or the output capacitor voltage V_{Co}) of the power conversion circuit 110 in step S210. In addition, the processor 121 may use the output current and the output capacitor voltage V_{Co} of the power conversion circuit 110 to calculate the output power Po in step S210. The processor 121 may use the output capacitor voltage V_{Co}, the output power Po, and the first time information to calculate the current output capacitor value of the output capacitor 113 of the power conversion circuit 110 in step S220, and/or the processor 121 may use the input capacitor voltage V_{Cin}, the output power Po, and the second time information to calculate the current input capacitor value of the input capacitor 111 of the power conversion circuit 110 in step S220. The processor 121 may trigger a notification based on the current input capacitor value and/or the current output capacitor value in step S230.

Based on actual design/application, in some embodiments, the time information in step S210 includes the time duration from time point t₁ to time point t₂ shown in FIG. 4, and/or the time duration from time point t₂ to time point t₃ shown in FIG. 4. The time point t₁ is a power-off time point when the input current I_{IN} (input voltage V_{IN}) of the power conversion circuit 110 is powered off (i.e., the input current I_{IN} turns to 0 or it is determined that the input voltage V_{IN} starts to decline), the time point t₂ is a step-down start time point when the output capacitor voltage V_{Co} of the power conversion circuit 110 is stepped down in response to the input current I_{IN} (input voltage V_{IN}) being powered off, and the time point t₃ is a step-down threshold time point when the output capacitor voltage V_{Co} steps down to a certain threshold level (e.g., the voltage level V_{b} shown in FIG. 4). The voltage level V_{b} may be a voltage value set based on actual design. The processor 121 may use the capacitor voltage (input capacitor voltage V_{Cin} and output capacitor voltage V_{Co}) to measure the time information (the time duration from time point t₁ to time point t₂ and/or the time duration from time point t₂ to time point t₃ shown in FIG. 4) in step S210.

In step S220, the processor 121 of the calculation circuit 120 may use the capacitor voltage, the output power Po and the time information to calculate the current capacitor value of the power conversion circuit 110. Based on actual design/application, in some embodiments, the current capacitor value includes the current input capacitor value (the capacitor value of the input capacitor 111 of the power conversion circuit 110) and/or the current output capacitor value (the capacitor value of the output capacitor 113 of the power conversion circuit 110). The specific calculation example of the current capacitor value is described below. It should be emphasized that, in other embodiments, the specific calculation methods of the current capacitor value are not limited to the following content.

In some embodiments, the current capacitor value includes a current input capacitor value Cᵢₙ of the input capacitor 111 of the power conversion circuit 110. The processor 121 may calculate Cᵢₙ = 2*Po*( t₂ - t₁) / (V₁² - V₂²) in step S220, where Po is the output power of the power conversion circuit 110, (t₂ - t₁) is the time duration from time point t₁ to time point t₂ shown in FIG. 4, V₁ is the voltage level of the input capacitor voltage V_{Cin} at time point t₁, and V₂ is the voltage level of the input capacitor voltage V_{Cin} at time point t₂.

In some embodiments, the current capacitor value includes the current output capacitor value Cₒᵤₜ of the output capacitor 113 of the power conversion circuit 110. The processor 121 may calculate Cₒᵤₜ =2*Po*(t₃- t₂)/(Vₐ²- V_{b}²) in step S220, where Po is the output power of the power conversion circuit 110, (t₃ - t₂) is the time duration from time point t₂ to time point t₃ shown in FIG. 4, Vₐ is the voltage level of the output capacitor voltage V_{Co} at time point t₂, and V_{b} is the voltage level (threshold level of the hold-up time) of the output capacitor voltage V_{Co} at time point t₃. In other embodiments, the voltage level V₂ may be a voltage value set based on an actual design, and the voltage level of the time point t₂ and the corresponding output capacitor voltage V_{Co} are decided by stepping down the input capacitor voltage V_{Cin} to the voltage level V₂, the disclosure is not limited thereto.

Referring to FIG. 1 and FIG. 2, in step S230, the calculation circuit 120 may trigger a notification based on the current capacitor value (the current input capacitor value Cᵢₙ and/or the current output capacitor value Cₒᵤₜ). For example, in some embodiments, the processor 121 of the calculation circuit 120 may notify/transmit the current capacitor value to the system circuit 10 outside the power supply 100. At this time, the system circuit 10 may present the current capacitor value in real time, so the user may refer to the current capacitor value to decide whether to replace the power supply 100 (or the power conversion circuit 110). In some other embodiments, the processor 121 of the calculation circuit 120 may calculate the capacitance attentuation rate based on an initial capacitor value Cᵢₙᵢₜᵢₐₗ and the current capacitor value C_{now} (current input capacitor value Cᵢₙ and/or current output capacitor value Cₒᵤₜ), and notify/transmit the capacitance attenuation rate corresponding to the current output capacitor value Cₒᵤₜ to the system circuit 10, so that the user may refer to the capacitance attenuation rate to decide whether to replace the power supply 100 (or power conversion circuit 110).

In some other embodiments, the processor 121 of the calculation circuit 120 may decide whether to issue a warning to notify the system circuit 10 outside the power supply 100 based on the current capacitor value C_{now} (current input capacitor value Cᵢₙ and/or current output capacitor value Cₒᵤₜ), so that the system circuit 10 notifies the user to replace the power supply 100 (or power conversion circuit 110). In yet some other embodiments, the processor 121 of the calculation circuit 120 may calculate the capacitance attenuation rate based on an initial capacitor value Cᵢₙᵢₜᵢₐₗ and the current capacitor value C_{now} (current input capacitor value Cᵢₙ and/or current output capacitor value Cₒᵤₜ), and decide whether to send a warning to the system circuit 10 based on the capacitance attennuation rate corresponding to the current capacitor value C_{now}, so that the system circuit 10 notifies the user to replace the power supply 100 (or power conversion circuit 110).

The initial capacitor value Cᵢₙᵢₜᵢₐₗ may be decided according to actual design. For example, the processor 121 of the calculation circuit 120 may calculate the capacitance attenuation rate (C_{now}/Cᵢₙᵢₜᵢₐₗ)*100%, and store (update) the calculated current capacitor value C_{now} and the capacitance attenuation rate in the non-volatile memory. The processor 121 of the calculation circuit 120 may check whether the stored capacitance attenuation rate is lower than a certain attenuation rate threshold value (e.g., 50% or other values) at every boot-up. When the capacitance attenuation rate is lower than the attenuation rate threshold value, the processor 121 of the calculation circuit 120 may send a warning to the system circuit 10. At this time, the system circuit 10 may notify the user to replace the power supply 100 (or the power conversion circuit 110) based on the warning from the calculation circuit 120 in real time.

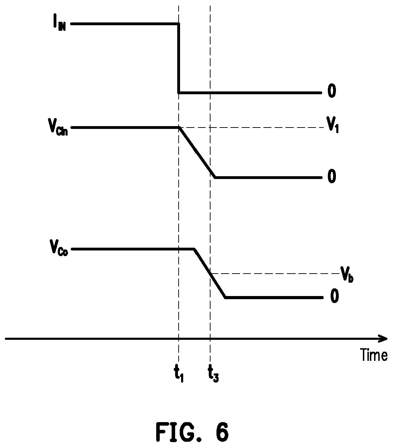

FIG. 5 is a schematic flowchart of a capacitor aging detection method according to another embodiment of the disclosure. Referring to FIG. 1 and FIG. 5, in step S510, the processor 121 of the calculation circuit 120 may measure the input capacitor voltage Vein and the output capacitor voltage V_{Co} of the power conversion circuit 110. FIG. 6 is a waveform schematic diagram of an input current I_{IN}, an input capacitor voltage V_{Cin}, and an output capacitor voltage V_{Co} according to an embodiment of the disclosure. The horizontal axis shown in FIG. 6 represents time, and the vertical axis respectively represents current (corresponding to input current I_{IN}) and voltage (corresponding to input capacitor voltage V_{Cin} and output capacitor voltage V_{Co}). Referring to FIG. 5 and FIG. 6, when it is detected that the input current I_{IN} is 0, it is determined that a power-off occurs. In other embodiments, when the voltage detection circuit detects that the input voltage V_{IN} drops to the step-down threshold, it is determined that the power-off occurs. The input current I_{IN} (input voltage V_{IN}) is powered off at time point t₁. When the power switch 114 is turned off, or when the power source (not shown) of the power supply 100 stops providing the input power Pin, the input capacitor voltage V_{Cin} and the output capacitor voltage V_{Co} of the power conversion circuit 110 are stepped down in response to the input current I_{IN} (input voltage V_{IN}) being powered off, as shown in FIG. 6.

In step S520, the processor 121 of the calculation circuit 120 may use the input capacitor voltage V_{Cin} and the output capacitor voltage V_{Co} to calculate the current hold-up time of the power conversion circuit 110. For example, the time point t₁ shown in FIG. 6 is a power-off time point when the input capacitor voltage V_{Cin} is stepped down in response to the input current I_{IN} (input voltage V_{IN}) of the power conversion circuit 110 being powered off, and the time point t₃ shown in FIG. 6 is a step-down threshold time point when the output capacitor voltage V_{Co} is stepped down to a certain threshold level (e.g., the voltage level V_{b} shown in FIG. 6) in response to the input current I_{IN} (input voltage V_{IN}) being powered off. The processor 121 may use the input capacitor voltage V_{Cin} and the output capacitor voltage V_{Co} to measure the current hold-up time tₕᵤ (the time duration from time point t₁ to time point t₃) in step S520. For example, the processor 121 may calculate tₕᵤ = t₃ - t₁.

In step S530, the processor 121 of the calculation circuit 120 may trigger a notification based on the current hold-up time. For example, in some embodiments, the calculation circuit 120 may notify/transmit the current hold-up time to the system circuit 10 outside the power supply 100. At this time, the system circuit 10 may present the current hold-up time in real time, so the user may refer to the current hold-up time to decide whether to replace the power supply 100 (or the power conversion circuit 110).

In some other embodiments, the processor 121 of the calculation circuit 120 may decide whether to issue a warning to notify the system circuit 10 outside the power supply 100 based on the current hold-up time. For example, the processor 121 of the calculation circuit 120 may store (update) the calculated current hold-up time in the non-volatile memory. The processor 121 of the calculation circuit 120 may check whether the stored current hold-up time is lower than a certain hold-up time threshold value at every boot-up. When the current hold-up time is lower than the hold-up time threshold value, the processor 121 of the calculation circuit 120 may send a warning to the system circuit 10. At this time, the system circuit 10 may notify the user to replace the power supply 100 (or the power conversion circuit 110) based on the warning from the calculation circuit 120 in real time.

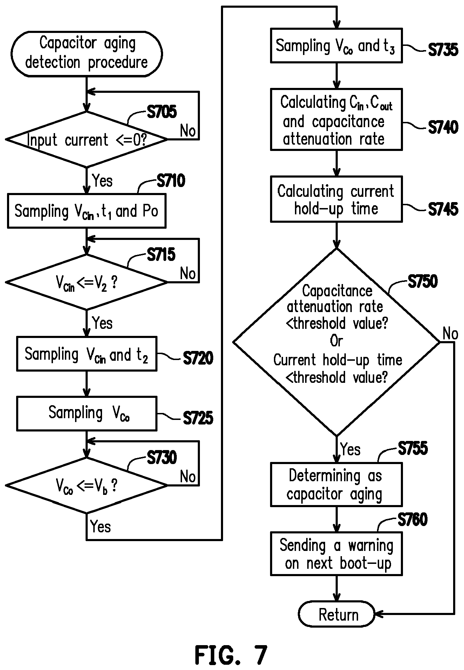

FIG. 7 is a schematic flowchart of a capacitor aging detection method according to yet another embodiment of the disclosure. Referring to FIG. 1 and FIG. 7, in step S705, the processor 121 of the calculation circuit 120 may measure the input current of the power conversion circuit 110 and determine whether the input current is less than or equal to zero. When the input current is less than or equal to 0 (the determination result of step S705 is "Yes", i.e., the input voltage V_{IN} is powered off), the processor 121 of the calculation circuit 120 may proceed to step S710 to sample the input capacitor voltage V_{Cin}, the time point t₁, and the output power Po. In step S715, the processor 121 of the calculation circuit 120 may determine whether the input capacitor voltage V_{Cin} is less than or equal to the voltage level V₂. When the input capacitor voltage V_{Cin} is less than or equal to the voltage level V₂ (the determination result of step S715 is "Yes"), the processor 121 of the calculation circuit 120 may proceed to step S720 to sample the input capacitor voltage V_{Cin} and the time point t₂.

In step S725, the processor 121 of the calculation circuit 120 may sample the output capacitor voltage V_{Co}. In step S730, the processor 121 of the calculation circuit 120 may determine whether the output capacitor voltage Vco is less than or equal to the voltage level V_{b}. When the output capacitor voltage Vco is less than or equal to the voltage level V_{b} (the determination result of step S730 is "Yes"), the processor 121 of the calculation circuit 120 may proceed to step S735 to sample the output capacitor voltage Vco and the time point t₃. In step S740, the processor 121 of the calculation circuit 120 may calculate the current input capacitor Cᵢₙ, the current output capacitor Cₒᵤₜ, and the capacitance attenuation rate. In step S745, the calculation circuit 120 may calculate the current hold-up time.

In step S750, the processor 121 of the calculation circuit 120 may determine whether the capacitance attenuation rate is less than the attenuation rate threshold value, and/or determine whether the current hold-up time is less than the hold-up time threshold value. When the capacitance attenuation rate is not less than the attenuation rate threshold value and the current hold-up time is not less than the hold-up time threshold value (the determination result of step S750 is "No"), the processor 121 of the calculation circuit 120 may end the capacitor aging detection procedure shown in FIG. 7 and return to the main procedure. When the capacitance attenuation rate is less than the attenuation rate threshold value or the current hold-up time is less than the hold-up time threshold value (the determination result of step S750 is "Yes"), the processor 121 of the calculation circuit 120 may proceed to step S755 to determine that the capacitor of the power conversion circuit 110 has aged. In step S760, the processor 121 of the calculation circuit 120 may send a warning to notify the system circuit 10 outside the power supply 100, and then end the capacitance aging detection procedure shown in FIG. 7 and return to the main procedure. At this time, the system circuit 10 may notify the user to replace the power supply 100 (or the power conversion circuit 110) based on the warning from the calculation circuit 120 in real time.

According to different design requirements, in some embodiments, the system circuit 10, the calculation circuit 120, and/or the processor 121 may be implemented by a hardware circuit. In other embodiments, the system circuit 10, the calculation circuit 120, and/or the processor 121 may be implemented by firmware, software (i.e., a program), or a combination of the two. In some other embodiments, the system circuit 10, the calculation circuit 120, and/or the processor 121 may be implemented by a combination of hardware, firmware, and software.

In terms of hardware, the above-mentioned system circuit 10, calculation circuit 120, and/or processor 121 may be implemented as a logic circuit on an integrated circuit. For example, the above-mentioned related functions of the system circuit 10, calculation circuit 120, and/or processor 121 may be implemented in one or more controllers, microcontrollers, microprocessors, application-specific integrated circuits (ASIC), digital signal processor (DSP), field programmable gate array (FPGA), and/or various logic blocks, modules, and circuits in other processing units. The above-mentioned related functions of the system circuit 10, calculation circuit 120, and/or processor 121 may be implemented as hardware circuits by using hardware description languages (e.g., Verilog HDL or VHDL), or other suitable programming languages, such as various logic blocks, modules, and circuits in integrated circuits.

In terms of software and/or firmware, the above-mentioned related functions of the system circuit 10, calculation circuit 120, and/or processor 121 may be implemented as programming codes. For example, the system circuit 10, calculation circuit 120, and/or processor 121 may be implemented using general programming languages (e.g., C, C++, or assembly language) or other suitable programming languages. The programming code may be recorded/stored in a "non-transitory computer readable medium". In some embodiments, the non-transitory computer readable medium includes, for example, a semiconductor memory and/or a storage device. The semiconductor memory includes a memory card, a read only memory (ROM), a flash memory, a programmable logic circuit, or other semiconductor memories. The storage device includes a tape, a disk, a hard disk drive (HDD), a solid-state drive (SSD), or other storage devices. An electronic device (e.g., a central processing unit (CPU), a controller, a microcontroller, or a microprocessor) may read and execute the programming code from the non-transitory computer readable medium, thereby achieving related functions of the system circuit 10, calculation circuit 120, and/or processor 121.

To sum up, the power supply 100 according to the embodiments of the disclosure may generate information about capacitor aging (such as the current capacitor value or the current hold-up time of the power conversion circuit 110) in real time. In some embodiments, the calculation circuit 120 may notify/provide the current capacitor aging information to the system circuit 10 outside the power supply 100, so the user may refer to the capacitor aging information to decide whether to replace the power supply 100. In other embodiments, the calculation circuit 120 may decide whether to send a warning based on the information about the current capacitor aging (notify/provide the capacitor aging warning to the system circuit 10 outside the power supply 100), thereby the system circuit 10 notifies the user to replace the power supply 100. Therefore, users may self-assess whether to replace the power supply 100 preventively based on the information about the current capacitor aging, so as to avoid unnecessary energy waste and equipment abnormalities.

## Claims

1. A calculation circuit (120), comprising:
an output current detection circuit (124), coupled to a power conversion circuit (110) to detect an output current of the power conversion circuit (110);
an output voltage detection circuit (125), coupled to the power conversion circuit (110) to detect an output capacitor voltage (V_{Co}) of an output capacitor (113) of the power conversion circuit (110);
a processor (121), coupled to the output current detection circuit (124) and the output voltage detection circuit (125), calculating output power (Po) of the power conversion circuit (110) by using the output current and the output capacitor voltage (V_{Co}), wherein the processor (121) calculates a current output capacitor value (Cₒᵤₜ) of the power conversion circuit (110) by using the output capacitor voltage (V_{Co}), the output power (Po), and first time information, and triggers a notification based on the current output capacitor value (Cₒᵤₜ);
an input voltage detection circuit (123), coupled to the processor (121) and coupling to the power conversion circuit (110) to detect an input capacitor voltage (V_{Cin}) of an input capacitor (111) of the power conversion circuit (110), wherein, when the input voltage detection circuit (123) detects that the input capacitor voltage (V_{Cin}) steps down, it is determined that a power-off occurs;
**characterized in** further comprising
an input current detection circuit (122), coupled to the processor (121) and coupling to the power conversion circuit (110) to detect an input current (I_{IN}) flowing through a power switch (114) of the power conversion circuit (110) to the input capacitor (111) of the power conversion circuit (110), wherein, when the input current detection circuit (122) detects that the input current (I_{IN}) turns to 0, due to the power switch (114) being turned off, it is determined that a power-off occurs.

2. The calculation circuit (120) according to claim 1, wherein the first time information comprises a time duration from a first time point (t₂) to a second time point (t₃), wherein the first time point (t₂) is a step-down start time point when the output capacitor voltage (V_{Co}) is stepped down in response to an input voltage (V_{IN}) of the power conversion circuit (110) being powered off, and the second time point (t₃) is a step-down threshold time point when the output capacitor voltage (Vco) steps down to a threshold level.

3. The calculation circuit (120) according to any one of claims 1 to 2, wherein,
The calculation circuit (120) notifies the current output capacitor value (Cₒᵤₜ) or a capacitance attenuation rate corresponding to the current output capacitor value (Cₒᵤₜ) to a system circuit (10); or
the calculation circuit (120) decides whether to send a warning to notify the system circuit (10) based on the current output capacitance value or the capacitance attenuation rate.

4. The calculation circuit (120) according to claim 3, wherein the calculation circuit (120) calculates the capacitance attenuation rate based on an initial capacitor value (Cᵢₙᵢₜᵢₐₗ) and the current output capacitor value (Cₒᵤₜ).

5. The calculation circuit (120) according to any one of claims 1 to 4, wherein the processor (121) calculates a current input capacitor value (Cᵢₙ) of an input capacitor (111) of the power conversion circuit (110) by using an input capacitor voltage (Vein), the output power (Po), and second time information, and the processor (121) further triggers the notification based on the current input capacitor value (Cᵢₙ).

6. The calculation circuit (120) according to claim 5, wherein the second time information comprises a time duration from a first time point (t₁) to a second time point (t₂), wherein the first time point (t₁) is a power-off time point when an input voltage (V_{IN}) of the power conversion circuit (110) is powered off, the second time point (t₂) is a step-down start time point when the output capacitor voltage (V_{Co}) is stepped down in response to the input voltage (V_{IN}) of the power conversion circuit (110) being powered off.

7. A power supply (100), comprising:
a power conversion circuit (110), converting an input voltage (V_{IN}) into an output voltage to obtain output power (Po); and
a calculation circuit (120), coupled to the power conversion circuit (110) to measure a capacitor voltage, the output power (Po), and time information of the power conversion circuit (110), wherein the calculation circuit (120) calculates a current capacitor value (C_{now}) of the power conversion circuit (110) by using the capacitor voltage, the output power (Po), and the time information, and triggers a notification based on the current capacitor value (C_{now});
wherein the power conversion circuit (110) comprises a power switch (114) and an input capacitor (111), the calculation circuit (120) detects an input capacitor voltage (V_{Cin}) of the input capacitor (111), the calculation circuit (120) determines that a power-off occurs when the input voltage detection circuit (123) detects that the input capacitor voltage (V_{Cin}) steps down,
**characterized in that** the
calculation circuit (120) detects an input current (I_{IN}) flowing through the power switch (114) to the input capacitor (111), and the calculation circuit (120) determines that a power-off occurs when the calculation circuit (120) detects that the input current (I_{IN}) turns to 0 due to the power switch (114) being turned off.

8. The power supply (100) according to claim 7, wherein the calculation circuit (120) is the calculation circuit (120) in any one of claims 1 to 6.

9. A capacitor aging detection method of a power supply (100), comprising:
measuring a capacitor voltage, output power (Po), and time information of a power conversion circuit (110), wherein the power conversion circuit (110) is used to convert an input voltage (V_{IN}) into an output voltage to obtain the output power (Po), and the power conversion circuit (110) comprises a power switch (114) and an input capacitor (111);
calculating a current capacitor value (C_{now}) of the power conversion circuit (110) by using the capacitor voltage, the output power (Po), and the time information;
triggering a notification based on the current capacitor value (C_{now});
detecting an input capacitor voltage (V_{Cin}) of the input capacitor (111) of the power conversion circuit (110);
determining that a power-off occurs when the input voltage detection circuit (123) detects that the input capacitor voltage (V_{Cin}) steps down; **characterized in**
detecting an input current (I_{IN}) flowing through the power switch (114) to the input capacitor (111); and
determining that a power-off occurs when the input current (I_{IN}) is detected to turn to 0 due to the power switch (114) being turned off.

10. The capacitor aging detection method according to claim 9, wherein the current capacitor value (C_{now}) comprises a current input capacitor value (Cᵢₙ) of an input capacitor (111) of the power conversion circuit (110), the capacitor voltage comprises an input capacitor voltage (V_{Cin}) of the input capacitor (111), the time information comprises a time duration from a first time point (t₁) to a second time point (t₂), the first time point (t₁) is a power-off time point when the input voltage (V_{IN}) of the power conversion circuit (110) is powered off, and the second time point (t₂) is a step-down start time point when an output capacitor voltage (V_{Co}) of an output capacitor (113) of the power conversion circuit (110) is stepped down in response to the input voltage (V_{IN}) being powered off.

11. The capacitor aging detection method according to any one of claims 9 to 10, wherein the current capacitor value (C_{now}) comprises a current output capacitor value (Cₒᵤₜ) of an output capacitor (113) of the power conversion circuit (110), the capacitor voltage comprises an output capacitor voltage (V_{Co}) of the output capacitor (113), the time information comprises a time duration from a first time point (t₂) to a second time point (t₃), the first time point (t₂) is a step-down start time point when the output capacitor voltage (V_{Co}) is stepped down in response to the input voltage (V_{IN}) of the power conversion circuit (110) being powered off, and the second time point (t₃) is a step-down threshold time point when the output capacitor voltage (V_{Co}) steps down to a threshold level.

12. The capacitor aging detection method according to any one of claims 9 to 11, further comprising:
notifying the current capacitor value (C_{now}) or a capacitance attenuation rate corresponding to the current capacitor value (C_{now}) to a system circuit (10); or
deciding whether to send a warning to notify the system circuit (10) outside the power supply (100) based on the current capacitance value or the capacitance attenuation rate.

13. The capacitor aging detection method according to claim 12, further comprising:
calculating the capacitance attenuation rate based on an initial capacitor value (Cᵢₙᵢₜᵢₐₗ) and the current capacitor value (C_{now}).

14. A calculation circuit (120), comprising:
an input voltage detection circuit (123), coupled to a power conversion circuit (110) to detect an input capacitor voltage (V_{Cin}) of the power conversion circuit (110);
an output voltage detection circuit (125), coupled to the power conversion circuit (110) to detect an output capacitor voltage (V_{Co}) of the power conversion circuit (110);
a processor (121), coupled to the input voltage detection circuit (123) and the output voltage detection circuit (125), calculating current hold-up time by using the input capacitor voltage (V_{Cin}) and the output capacitor voltage (V_{Co}), wherein the processor (121) triggers a notification based on the current hold-up time;
an input voltage detection circuit (123), coupled to the processor (121) and coupling to the power conversion circuit (110) to detect an input capacitor voltage (V_{Cin}) of an input capacitor (111) of the power conversion circuit (110), wherein, when the input voltage detection circuit (123) detects that the input capacitor voltage (V_{Cin}) steps down, it is determined that a power-off occurs;
**characterized in**
an input current detection circuit (122), coupled to the processor (121) and coupling to the power conversion circuit (110) to detect an input current (I_{IN}) flowing through a power switch (114) of the power conversion circuit (110) to the input capacitor (111) of the power conversion circuit (110), wherein, when the input current detection circuit (122) detects that the input current (I_{IN}) turns to 0 due to the power switch (114) being turned off, it is determined that a power-off occurs.

15. The calculation circuit (120) according to claim 14, wherein,
the calculation circuit (120) notifies the current hold-up time to a system circuit (10) outside the power supply (100); or
the calculation circuit (120) decides whether to send a warning to notify the system circuit (10) outside the power supply (100) based on the current hold-up time.

16. A power supply (100), comprising:
a power conversion circuit (110), converting an input voltage (V_{IN}) into an output voltage to obtain output power (Po); and
a calculation circuit (120), coupled to the power conversion circuit (110) to measure an input capacitor voltage (V_{Cin}) and an output capacitor voltage (V_{Co}) of the power conversion circuit (110), wherein the calculation circuit (120) calculates current hold-up time of the power conversion circuit (110) by using the input capacitor voltage (V_{Cin}) and the output capacitor voltage (V_{Co}), and triggers a notification based on the current hold-up time;
wherein the power conversion circuit (110) comprises a power switch (114) and an input capacitor (111), the calculation circuit (120) detects an input capacitor voltage (V_{Cin}) of the input capacitor (111), the calculation circuit (120) determines that a power-off occurs when the input voltage detection circuit (123) detects that the input capacitor voltage (V_{Cin}) steps down,
**characterized in that** the calculation circuit (120) detects an input current (I_{IN}) flowing through the power switch (114) to the input capacitor (111), and the calculation circuit (120) determines that a power-off occurs when the calculation circuit (120) detects that the input current (I_{IN}) turns to 0 due to the power switch (114) being turned off.

17. The power supply (100) according to claim 16, wherein the calculation circuit (120) is the calculation circuit (120) in any one of claims 14 to 15.

18. A capacitor aging detection method of a power supply (100), comprising:
measuring an input capacitor voltage (V_{Cin}) and an output capacitor voltage (V_{Co}) of a power conversion circuit (110), wherein the power conversion circuit (110) comprises a power switch (114) and an input capacitor (111);
calculating current hold-up time of the power conversion circuit (110) by using the input capacitor voltage (V_{Cin}) and output capacitor voltage (V_{Co});
triggering a notification based on the current hold-up time;
detecting an input capacitor voltage (V_{Cin}) of the input capacitor (111);
determining that a power-off occurs when the input voltage detection circuit (123) detects that the input capacitor voltage (V_{Cin}) steps down; **characterized in**
detecting an input current (I_{IN}) flowing through the power switch (114) to the input capacitor (111); and
determining that a power-off occurs when the input current (I_{IN}) is detected to turn to 0 due to the power switch (114) being turned off.

19. The capacitor aging detection method according to claim 18, further comprising:
notifying the current hold-up time to a system circuit (10) outside the power supply (100); or
deciding whether to send a warning to notify the system circuit (10) outside the power supply (100) based on the current hold-up time.

## Patentansprüche

1. Berechnungsschaltung (120), umfassend:
eine Ausgangsstrom-Erfassungsschaltung (124), die mit einer Leistungsumwandlungsschaltung (110) gekoppelt ist, um einen Ausgangsstrom der Leistungsumwandlungsschaltung (110) zu erfassen;
eine Ausgangsspannungs-Erfassungsschaltung (125), die mit der Leistungsumwandlungsschaltung (110) gekoppelt ist, um eine Ausgangskondensatorspannung (V_{Co}) eines Ausgangskondensators (113) der Leistungsumwandlungsschaltung (110) zu erfassen;
einen Prozessor (121), der mit der Ausgangsstrom-Erfassungsschaltung (124) und der Ausgangsspannungs-Erfassungsschaltung (125) gekoppelt ist, berechnend Ausgangsleistung (Po) der Leistungsumwandlungsschaltung (110) unter Verwendung des Ausgangsstroms und der Ausgangskondensatorspannung (V_{Co}), wobei der Prozessor (121) einen aktuellen Ausgangskondensatorwert (Cₒᵤₜ) der Leistungsumwandlungsschaltung (110) unter Verwendung der Ausgangskondensatorspannung (V_{Co}), der Ausgangsleistung (Po) und ersten Zeitinformationen berechnet, und eine Meldung auf der Grundlage des aktuellen Ausgangskondensatorwerts (Cₒᵤₜ) auslöst;
eine Eingangsspannungs-Erfassungsschaltung (123), die mit dem Prozessor (121) gekoppelt ist und mit der Leistungsumwandlungsschaltung (110) gekoppelt ist, um eine Eingangskondensatorspannung (V_{Cin}) eines Eingangskondensators (111) der Leistungsumwandlungsschaltung (110) zu erfassen, wobei, wenn die Eingangsspannungs-Erfassungsschaltung (123) erfasst, dass die Eingangskondensatorspannung (V_{Cin}) heruntertransformiert, bestimmt wird, dass ein Ausschalten erfolgt;
**gekennzeichnet durch** ferner umfassend
eine Eingangsstrom-Erfassungsschaltung (122), die mit dem Prozessor (121) gekoppelt ist und mit der Leistungsumwandlungsschaltung (110) gekoppelt ist, um einen Eingangsstrom (I_{IN}) zu erfassen, der durch einen Leistungsschalter (114) der Leistungsumwandlungsschaltung (110) zu dem Eingangskondensator (111) der Leistungsumwandlungsschaltung (110) fließt, wobei, wenn die Eingangsstrom-Erfassungsschaltung (122) erfasst, dass der Eingangsstrom (I_{IN}) aufgrund des Ausschaltens des Leistungsschalters (114) auf 0 geht, bestimmt wird, dass ein Ausschalten erfolgt.

2. Berechnungsschaltung (120) nach Anspruch 1, wobei die ersten Zeitinformationen eine Zeitdauer von einem ersten Zeitpunkt (t₂) bis zu einem zweiten Zeitpunkt (t₃) umfassen, der erste Zeitpunkt (t₂) ein Heruntertransformations-Startzeitpunkt ist, wenn die Ausgangskondensatorspannung (V_{Co}) als Reaktion auf eine Eingangsspannung (V_{IN}) der Leistungsumwandlungsschaltung (110), die ausgeschaltet wird, heruntertransformiert wird, und der zweite Zeitpunkt (t₃) ein Heruntertransformations-Schwellenwertzeitpunkt ist, wenn die Ausgangskondensatorspannung (V_{Co}) auf ein Schwellenwertniveau heruntertransformiert.

3. Berechnungsschaltung (120) nach einem der Ansprüche 1 bis 2, wobei
die Berechnungsschaltung (120) den aktuellen Ausgangskondensatorwert (Cₒᵤₜ) oder eine dem aktuellen Ausgangskondensatorwert (Cₒᵤₜ) entsprechende Kapazitätsdämpfungsrate an eine Systemschaltung (10) meldet; oder
die Berechnungsschaltung (120) entscheidet, ob eine Warnung gesendet werden soll, um der Systemschaltung (10) auf der Grundlage des Stromausgangs-Kapazitätswerts oder der Kapazitätsdämpfungsrate Meldung zu leisten.

4. Berechnungsschaltung (120) nach Anspruch 3, wobei die Berechnungsschaltung (120) die Kapazitätsdämpfungsrate auf der Grundlage eines anfänglichen Kondensatorwerts (Cᵢₙᵢₜᵢₐₗ) und des aktuellen Ausgangskondensatorwerts (Cₒᵤₜ) berechnet.

5. Berechnungsschaltung (120) nach einem der Ansprüche 1 bis 4, wobei der Prozessor (121) einen aktuellen Eingangskondensatorwert (Cᵢₙ) eines Eingangskondensators (111) der Leistungsumwandlungsschaltung (110) unter Verwendung einer Eingangskondensatorspannung (V_{Cin}), der Ausgangsleistung (Po) und zweiter Zeitinformationen berechnet, und der Prozessor (121) ferner die Meldung auf der Grundlage des aktuellen Eingangskondensatorwerts (Cᵢₙ) auslöst.

6. Berechnungsschaltung (120) nach Anspruch 5, wobei die zweiten Zeitinformationen eine Zeitdauer von einem ersten Zeitpunkt (t₁) bis zu einem zweiten Zeitpunkt (t₂) umfassen, der erste Zeitpunkt (t₁) ein Ausschaltzeitpunkt ist, wenn eine Eingangsspannung (V_{IN}) der Leistungsumwandlungsschaltung (110) ausgeschaltet wird, der zweite Zeitpunkt (t₂) ein Heruntertransformations-Startzeitpunkt ist, wenn die Ausgangskondensatorspannung (V_{Co}) als Reaktion auf das Ausschalten der Eingangsspannung (V_{IN}) der Leistungsumwandlungsschaltung (110) heruntertransformiert wird.

7. Stromversorgung (100), umfassend:
eine Leistungsumwandlungsschaltung (110), die eine Eingangsspannung (V_{IN}) in eine Ausgangsspannung umwandelt, um Ausgangsleistung (Po) zu erhalten; und
eine Berechnungsschaltung (120), die mit der Leistungsumwandlungsschaltung (110) gekoppelt ist, um eine Kondensatorspannung, die Ausgangsleistung (Po) und Zeitinformationen der Leistungsumwandlungsschaltung (110) zu messen, wobei die Berechnungsschaltung (120) einen aktuellen Kondensatorwert (C_{now}) der Leistungsumwandlungsschaltung (110) unter Verwendung der Kondensatorspannung, der Ausgangsleistung (Po) und der Zeitinformationen berechnet, und eine Meldung auf der Grundlage des aktuellen Kondensatorwerts (C_{now}) auslöst;
wobei die Leistungsumwandlungsschaltung (110) einen Leistungsschalter (114) und einen Eingangskondensator (111) umfasst, die Berechnungsschaltung (120) eine Eingangskondensatorspannung (V_{Cin}) des Eingangskondensators (111) erfasst, die Berechnungsschaltung (120) bestimmt, dass ein Ausschalten erfolgt, wenn die Eingangsspannungs-Erfassungsschaltung (123) erfasst, dass die Eingangskondensatorspannung (V_{Cin}) heruntertransformiert,
**dadurch gekennzeichnet, dass**
die Berechnungsschaltung (120) einen Eingangsstrom (I_{IN}) erfasst, der durch den Leistungsschalter (114) zu dem Eingangskondensator (111) fließt, und die Berechnungsschaltung (120) bestimmt, dass ein Ausschalten erfolgt, wenn die Berechnungsschaltung (120) erfasst, dass der Eingangsstrom (I_{IN}) aufgrund des Abschaltens des Leistungsschalters (114) auf 0 geht.

8. Stromversorgung (100) nach Anspruch 7, wobei die Berechnungsschaltung (120) die Berechnungsschaltung (120) nach einem der Ansprüche 1 bis 6 ist.

9. Verfahren zur Erfassung der Alterung eines Kondensators einer Stromversorgung (100), umfassend:
Messen einer Kondensatorspannung, einer Ausgangsleistung (Po) und von Zeitinformationen einer Leistungsumwandlungsschaltung (110), wobei die Leistungsumwandlungsschaltung (110) verwendet wird, um eine Eingangsspannung (V_{IN}) in eine Ausgangsspannung umzuwandeln, um die Ausgangsleistung (Po) zu erhalten, und die Leistungsumwandlungsschaltung (110) einen Leistungsschalter (114) und einen Eingangskondensator (111) umfasst;
Berechnen eines aktuellen Kondensatorwerts (C_{now}) der Leistungsumwandlungsschaltung (110) unter Verwendung der Kondensatorspannung, der Ausgangsleistung (Po) und der Zeitinformationen;
Auslösen einer Meldung auf der Grundlage des aktuellen Kondensatorwerts (C_{now});
Erfassen einer Eingangskondensatorspannung (V_{Cin}) des Eingangskondensators (111) der Leistungsumwandlungsschaltung (110);
Bestimmen, dass ein Ausschalten erfolgt, wenn die Eingangsspannungs-Erfassungsschaltung (123) erfasst, dass die Eingangskondensatorspannung (V_{Cin}) heruntertransformiert;
**gekennzeichnet durch**
Erfassen eines Eingangsstroms (I_{IN}), der durch den Leistungsschalter (114) zu dem Eingangskondensator (111) fließt; und
Bestimmen, dass ein Abschalten erfolgt, wenn erfasst wird, dass der Eingangsstrom (I_{IN}) aufgrund des Abschaltens des Leistungsschalters (114) auf 0 geht.

10. Verfahren zur Erfassung der Alterung eines Kondensators nach Anspruch 9,
wobei der aktuelle Kondensatorwert (C_{now}) einen aktuellen Eingangskondensatorwert (Cᵢₙ) eines Eingangskondensators (111) der Leistungsumwandlungsschaltung (110) umfasst, die Kondensatorspannung eine Eingangskondensatorspannung (V_{Cin}) des Eingangskondensators (111) umfasst, die Zeitinformationen eine Zeitdauer von einem ersten Zeitpunkt (t₁) bis zu einem zweiten Zeitpunkt (t₂) umfassen, der erste Zeitpunkt (t₁) ein Ausschaltzeitpunkt ist, wenn die Eingangsspannung (V_{IN}) der Leistungsumwandlungsschaltung (110) ausgeschaltet wird, und der zweite Zeitpunkt (t₂) ein Heruntertransformations-Startzeitpunkt ist, wenn eine Ausgangskondensatorspannung (V_{Co}) eines Ausgangskondensators (113) der Leistungsumwandlungsschaltung (110) als Reaktion auf das Ausschalten der Eingangsspannung (V_{IN}) heruntertransformiert wird.

11. Verfahren zur Erfassung der Alterung eines Kondensators nach einem der Ansprüche 9 bis 10,
wobei der aktuelle Kondensatorwert (C_{now}) einen aktuellen Ausgangskondensatorwert (Cₒᵤₜ) eines Ausgangskondensators (113) der Leistungsumwandlungsschaltung (110) umfasst, die Kondensatorspannung eine Ausgangskondensatorspannung (V_{Co}) des Ausgangskondensators (113) umfasst, die Zeitinformationen eine Zeitdauer von einem ersten Zeitpunkt (t₂) bis zu einem zweiten Zeitpunkt (t₃) umfassen, der erste Zeitpunkt (t₂) ein Heruntertransformations-Startzeitpunkt ist, wenn die Ausgangskondensatorspannung (V_{Co}) als Reaktion auf das Abschalten der Eingangsspannung (V_{IN}) der Leistungsumwandlungsschaltung (110) heruntertransformiert wird, und der zweite Zeitpunkt (t₃) ein Heruntertransformations-Schwellenwertzeitpunkt ist, wenn die Ausgangskondensatorspannung (V_{Co}) auf ein Schwellenwertniveau heruntertransformiert.

12. Verfahren zur Erfassung der Alterung eines Kondensators nach einem der Ansprüche 9 bis 11, ferner umfassend:
Melden der Systemschaltung (10) den aktuellen Kondensatorwert (C_{now}) oder eine dem aktuellen Kondensatorwert (C_{now}) entsprechende Kapazitätsdämpfungsrate; oder
Entscheiden, ob eine Warnung zur Meldung an die Systemschaltung (10) außerhalb der Stromversorgung (100) auf der Grundlage des aktuellen Kapazitätswerts oder der Kapazitätsdämpfungsrate gesendet werden soll.

13. Verfahren zur Erfassung der Alterung eines Kondensators nach Anspruch 12, ferner umfassend:
Berechnen der Kapazitätsdämpfungsrate auf der Grundlage eines anfänglichen Kondensatorwerts (Cᵢₙᵢₜᵢₐₗ) und des aktuellen Kondensatorwerts (C_{now}).

14. Berechnungsschaltung (120), umfassend:
eine Eingangsspannungs-Erfassungsschaltung (123), die mit einer Leistungsumwandlungsschaltung (110) gekoppelt ist, um eine Eingangskondensatorspannung (V_{Cin}) der Leistungsumwandlungsschaltung (110) zu erfassen;
eine Ausgangsspannungs-Erfassungsschaltung (125), die mit der Leistungsumwandlungsschaltung (110) gekoppelt ist, um eine Ausgangskondensatorspannung (V_{Co}) der Leistungsumwandlungsschaltung (110) zu erfassen;
einen Prozessor (121), der mit der Eingangsspannungs-Erfassungsschaltung (123) und der Ausgangsspannungs-Erfassungsschaltung (125) gekoppelt ist, berechnend die aktuelle Haltezeit unter Verwendung der Eingangskondensatorspannung (V_{Cin}) und der Ausgangskondensatorspannung (V_{Co}), wobei der Prozessor (121) eine Meldung auf der Grundlage der aktuellen Haltezeit auslöst;
eine Eingangsspannungs-Erfassungsschaltung (123), die mit dem Prozessor (121) gekoppelt ist und mit der Leistungsumwandlungsschaltung (110) gekoppelt ist, um eine Eingangskondensatorspannung (V_{Cin}) eines Eingangskondensators (111) der Leistungsumwandlungsschaltung (110) zu erfassen, wobei, wenn die Eingangsspannungs-Erfassungsschaltung (123) erfasst, dass die Eingangskondensatorspannung (V_{Cin}) heruntertransformiert, bestimmt wird, dass ein Ausschalten erfolgt;
**gekennzeichnet durch**
eine Eingangsstrom-Erfassungsschaltung (122), die mit dem Prozessor (121) gekoppelt ist und mit der Leistungsumwandlungsschaltung (110) gekoppelt ist, um einen Eingangsstrom (I_{IN}) zu erfassen, der durch einen Leistungsschalter (114) der Leistungsumwandlungsschaltung (110) zu dem Eingangskondensator (111) der Leistungsumwandlungsschaltung (110) fließt, wobei, wenn die Eingangsstrom-Erfassungsschaltung (122) erfasst, dass der Eingangsstrom (I_{IN}) aufgrund des Ausschaltens des Leistungsschalters (114) auf 0 geht, bestimmt wird, dass ein Ausschalten erfolgt.

15. Berechnungsschaltung (120) nach Anspruch 14, wobei
die Berechnungsschaltung (120) die aktuelle Haltezeit an eine Systemschaltung (10) außerhalb der Stromversorgung (100) meldet; oder
die Berechnungsschaltung (120) entscheidet, ob eine Warnung gesendet werden soll, um der Systemschaltung (10) außerhalb der Stromversorgung (100) auf der Grundlage der aktuellen Haltezeit Meldung zu leisten.

16. Stromversorgung (100), umfassend:
eine Leistungsumwandlungsschaltung (110), die eine Eingangsspannung (V_{IN}) in eine Ausgangsspannung umwandelt, um Ausgangsleistung (Po) zu erhalten; und
eine Berechnungsschaltung (120), die mit der Leistungsumwandlungsschaltung (110) gekoppelt ist, um eine Eingangskondensatorspannung (V_{Cin}) und eine Ausgangskondensatorspannung (V_{Co}) der Leistungsumwandlungsschaltung (110) zu messen, wobei die Berechnungsschaltung (120) die aktuelle Haltezeit der Leistungsumwandlungsschaltung (110) unter Verwendung der Eingangskondensatorspannung (V_{Cin}) und der Ausgangskondensatorspannung (V_{Co}) berechnet und eine Meldung auf der Grundlage der aktuellen Haltezeit auslöst;
wobei die Leistungsumwandlungsschaltung (110) einen Leistungsschalter (114) und einen Eingangskondensator (111) umfasst, die Berechnungsschaltung (120) eine Eingangskondensatorspannung (V_{Cin}) des Eingangskondensators (111) erfasst, die Berechnungsschaltung (120) bestimmt, dass ein Ausschalten erfolgt, wenn die Eingangsspannungs-Erfassungsschaltung (123) erfasst, dass die Eingangskondensatorspannung (V_{Cin}) heruntertransformiert,
**dadurch gekennzeichnet, dass**
die Berechnungsschaltung (120) einen Eingangsstrom (I_{IN}) erfasst, der durch den Leistungsschalter (114) zu dem Eingangskondensator (111) fließt, und die Berechnungsschaltung (120) bestimmt, dass ein Ausschalten erfolgt, wenn die Berechnungsschaltung (120) erfasst, dass der Eingangsstrom (I_{IN}) aufgrund des Abschaltens des Leistungsschalters (114) auf 0 geht.

17. Stromversorgung (100) nach Anspruch 16,
wobei die Berechnungsschaltung (120) die Berechnungsschaltung (120) in einem der Ansprüche 14 bis 15 ist.

18. Verfahren zur Erfassung der Alterung eines Kondensators einer Stromversorgung (100), umfassend:
Messen einer Eingangskondensatorspannung (V_{Cin}) und einer Ausgangskondensatorspannung (V_{Co}) einer Leistungsumwandlungsschaltung (110), wobei die Leistungsumwandlungsschaltung (110) einen Leistungsschalter (114) und einen Eingangskondensator (111) umfasst;
Berechnen der Stromhaltezeit der Leistungsumwandlungsschaltung (110) unter Verwendung der Eingangskondensatorspannung (V_{Cin}) und der Ausgangskondensatorspannung (V_{Co});
Auslösen einer Meldung auf der Grundlage der Stromhaltezeit;
Erfassen einer Eingangskondensatorspannung (V_{Cin}) des Eingangskondensators (111);
Bestimmen, dass ein Abschalten erfolgt, wenn die Eingangsspannungs-Erfassungsschaltung (123) erfasst, dass die Eingangskondensatorspannung (V_{Cin}) heruntertransformiert;
**gekennzeichnet durch**
Erfassen eines Eingangsstroms (I_{IN}), der durch den Leistungsschalter (114) zu dem Eingangskondensator (111) fließt; und
Bestimmen, dass ein Ausschalten erfolgt, wenn erfasst wird, dass der Eingangsstrom (I_{IN}) aufgrund des Ausschaltens des Leistungsschalters (114) auf 0 geht.

19. Verfahren zur Erfassung der Alterung eines Kondensators nach Anspruch 18, ferner umfassend:
Melden der aktuellen Haltezeit an eine Systemschaltung (10) außerhalb der Stromversorgung (100); oder
Entscheiden, ob eine Warnung zur Meldung an die Systemschaltung (10) außerhalb der Stromversorgung (100) auf der Grundlage der aktuellen Haltezeit gesendet werden soll.

## Revendications

1. Un circuit de calcul (120), comprenant :
un circuit (124) de détection de courant de sortie, relié à un circuit (110) de conversion de puissance pour détecter un courant de sortie du circuit (110) de conversion de puissance ;
un circuit (125) de détection de tension de sortie, relié au circuit (110) de conversion de puissance pour détecter une tension (V_{Co}) de condensateur de sortie d'un condensateur de sortie (113) du circuit (110) de conversion de puissance ;
un processeur (121), relié au circuit (124) de détection de courant de sortie et au circuit (125) de détection de tension de sortie, calculant la puissance de sortie (Po) du circuit (110) de conversion de puissance en utilisant le courant de sortie et la tension (V_{Co}) de condensateur de sortie, le processeur (121) calculant une valeur (Cₒᵤₜ) de condensateur de sortie de courant du circuit (110) de conversion de puissance en utilisant la tension (V_{Co}) de condensateur de sortie, la puissance de sortie (Po) et des premières informations temporelles, et déclenchant une notification basée sur la valeur (Cₒᵤₜ) de condensateur de sortie de courant ;
un circuit (123) de détection de tension d'entrée, relié au processeur (121) et relié au circuit (110) de conversion de puissance pour détecter une tension (V_{Cin}) de condensateur d'entrée d'un condensateur d'entrée (111) du circuit (110) de conversion de puissance, de sorte que, lorsque le circuit (123) de détection de tension d'entrée détecte que la tension (V_{Cin}) de condensateur d'entrée baisse, il est déterminé qu'une coupure de courant se produit ;
**caractérisé en ce qu'**il comprend en outre
un circuit (122) de détection de courant d'entrée, relié au processeur (121) et relié au circuit (110) de conversion de puissance pour détecter un courant d'entrée (I_{IN}) s'écoulant à travers un interrupteur d'alimentation (114) du circuit (110) de conversion de puissance vers le condensateur d'entrée (111) du circuit (110) de conversion de puissance, de sorte que, lorsque le circuit (122) de détection de courant d'entrée détecte que le courant d'entrée (I_{IN}) passe à 0, du fait de la mise sur arrêt de l'interrupteur d'alimentation (114), il est déterminé qu'une coupure de courant se produit.

2. Le circuit de calcul (120) selon la revendication 1, dans lequel les premières informations temporelles comprennent une durée allant d'un premier instant (t₂) à un deuxième instant (t₃), le premier instant (t₂) étant un instant de début de baisse lorsque la tension (V_{Co}) de condensateur de sortie baisse en réponse à la coupure d'une tension d'entrée (V_{IN}) du circuit (110) de conversion de puissance, et le deuxième instant (t₃) étant un instant de seuil de baisse lorsque la tension (V_{Co}) de condensateur de sortie baisse jusqu'à un niveau de seuil.

3. Le circuit de calcul (120) selon l'une quelconque des revendications 1 à 2, dans lequel,
le circuit de calcul (120) notifie à un circuit système (10) la valeur (Cₒᵤₜ) de condensateur de sortie de courant ou un taux d'atténuation de capacité correspondant à la valeur (Cₒᵤₜ) de condensateur de sortie de courant ; ou
le circuit de calcul (120) décide d'envoyer ou non un avertissement afin de transmettre une notification au circuit système (10) en fonction de la valeur de capacité de sortie de courant ou du taux d'atténuation de capacité.

4. Le circuit de calcul (120) selon la revendication 3, dans lequel le circuit de calcul (120) calcule le taux d'atténuation de capacité en fonction d'une valeur de condensateur initiale (Cᵢₙᵢₜᵢₐₗ) et de la valeur de condensateur de sortie de courant (Cₒᵤₜ).

5. Le circuit de calcul (120) selon l'une quelconque des revendications 1 à 4, dans lequel le processeur (121) calcule une valeur (Cᵢₙ) de condensateur d'entrée de courant d'un condensateur d'entrée (111) du circuit (110) de conversion de puissance en utilisant une tension (V_{Cin}) de condensateur d'entrée, la puissance de sortie (Po) et des deuxièmes informations temporelles, et le processeur (121) déclenche en outre la notification en fonction de la valeur (Cᵢₙ) de condensateur d'entrée de courant.

6. Le circuit de calcul (120) selon la revendication 5, dans lequel les deuxièmes informations temporelles comprennent une durée allant d'un premier instant (t₁) à un deuxième instant (t₂), le premier instant (t₁) étant un instant de coupure lorsqu'une tension d'entrée (V_{IN}) du circuit (110) de conversion de puissance est coupée, le deuxième instant (t₂) étant un instant de début de baisse lorsque la tension (V_{Co}) de condensateur de sortie baisse en réponse à la coupure de la tension d'entrée (V_{IN}) du circuit (110) de conversion de puissance.

7. Une alimentation électrique (100), comprenant :
un circuit (110) de conversion de puissance, convertissant une tension d'entrée (V_{IN}) en une tension de sortie pour obtenir une puissance de sortie (Po) ; et
un circuit de calcul (120), relié au circuit (110) de conversion de puissance pour mesurer une tension de condensateur, la puissance de sortie (Po) et des informations temporelles du circuit (110) de conversion de puissance, le circuit de calcul (120) calculant une valeur (C_{now}) de condensateur de courant du circuit (110) de conversion de puissance en utilisant la tension de condensateur, la puissance de sortie (Po) et les informations temporelles, et déclenchant une notification basée sur la valeur (C_{now}) de condensateur de courant ;
le circuit (110) de conversion de puissance comprenant un commutateur d'alimentation (114) et un condensateur d'entrée (111), le circuit de calcul (120) détectant une tension (V_{Cin}) de condensateur d'entrée du condensateur d'entrée (111), le circuit de calcul (120) déterminant qu'une mise hors tension se produit lorsque le circuit (123) de détection de tension d'entrée détecte que la tension (V_{Cin}) de condensateur d'entrée baisse,
**caractérisé en ce que** le circuit de calcul (120) détecte un courant d'entrée (I_{IN}) s'écoulant à travers l'interrupteur d'alimentation (114) vers le condensateur d'entrée (111), et le circuit de calcul (120) détermine qu'une mise hors tension se produit lorsque le circuit de calcul (120) détecte que le courant d'entrée (I_{IN}) passe à 0 du fait de la mise sur arrêt de l'interrupteur d'alimentation (114).

8. L'alimentation (100) selon la revendication 7, dans laquelle le circuit de calcul (120) est le circuit de calcul (120) selon l'une quelconque des revendications 1 à 6.

9. Un procédé de détection de vieillissement de condensateur d'une alimentation (100), comprenant :
le fait de mesurer une tension de condensateur, une puissance de sortie (Po) et des informations temporelles d'un circuit (110) de conversion de puissance, le circuit (110) de conversion de puissance étant utilisé pour convertir une tension d'entrée (V_{IN}) en une tension de sortie pour obtenir la puissance de sortie (Po), et le circuit (110) de conversion de puissance comprenant un interrupteur d'alimentation (114) et un condensateur d'entrée (111) ;
le fait de calculer une valeur (C_{now}) de condensateur de courant du circuit (110) de conversion de puissance en utilisant la tension de condensateur, la puissance de sortie (Po) et les informations temporelles ;
le fait de déclencher une notification en fonction de la valeur (C_{now}) de condensateur de courant ;
le fait de détecter une tension (V_{Cin}) de condensateur d'entrée du condensateur d'entrée (111) du circuit (110) de conversion de puissance ;
le fait de déterminer qu'une coupure de courant se produit lorsque le circuit (123) de détection de tension d'entrée détecte que la tension (V_{Cin}) de condensateur d'entrée baisse ; **caractérisé par**
le fait de détecter un courant d'entrée (I_{IN}) passant à travers l'interrupteur d'alimentation (114) vers le condensateur d'entrée (111) ; et
le fait de déterminer qu'une coupure de courant se produit lorsque le courant d'entrée (I_{IN}) est détecté comme tombant à 0 du fait de la mise sur arrêt de l'interrupteur d'alimentation (114).

10. Le procédé de détection de vieillissement de condensateur selon la revendication 9, dans lequel la valeur (C_{now}) de condensateur de courant comprend une valeur (Cᵢₙ) de condensateur d'entrée de courant d'un condensateur d'entrée (111) du circuit (110) de conversion de puissance, la tension de condensateur comprend une tension (V_{Cin}) de condensateur d'entrée du condensateur d'entrée (111), les informations temporelles comprennent une durée allant d'un premier point temporel (t₁) à un deuxième point temporel (t₂), le premier point temporel (t₁) est un point temporel de coupure lorsque la tension d'entrée (V_{IN}) du circuit (110) de conversion de puissance est coupée, et le deuxième point temporel (t₂) est un point temporel de début de baisse lorsqu'une tension (V_{Co}) de condensateur de sortie d'un condensateur de sortie (113) du circuit (110) de conversion de puissance baisse en réponse à la coupure de la tension d'entrée (V_{IN}).

11. Le procédé de détection de vieillissement de condensateur selon l'une quelconque des revendications 9 à 10, dans lequel la valeur (C_{now}) de condensateur de courant comprend une valeur (Cₒᵤₜ) de condensateur de sortie de courant d'un condensateur de sortie (113) du circuit (110) de conversion de puissance, la tension de condensateur comprend une tension (V_{Co}) de condensateur de sortie du condensateur de sortie (113), les informations temporelles comprennent une durée temporelle allant d'un premier point temporel (t₂) à un deuxième point temporel (t₃), le premier point temporel (t₂) est un point temporel de début de baisse lorsque la tension (V_{Co}) de condensateur de sortie baisse en réponse à la coupure de la tension d'entrée (V_{IN}) du circuit (110) de conversion de puissance, et le deuxième point temporel (t₃) est un point temporel de seuil de baisse lorsque la tension (V_{Co}) de condensateur de sortie baisse jusqu'à un niveau de seuil.

12. Le procédé de détection de vieillissement de condensateur selon l'une quelconque des revendications 9 à 11, comprenant en outre :
le fait de notifier la valeur (C_{now}) de condensateur de courant ou un taux d'atténuation de capacité correspondant à la valeur (C_{now}) de condensateur de courant à un circuit système (10) ; ou
le fait de décider d'envoyer ou non un avertissement pour notifier le circuit système (10) en dehors de l'alimentation électrique (100) en fonction de la valeur de capacité de courant ou du taux d'atténuation de capacité.

13. Le procédé de détection de vieillissement de condensateur selon la revendication 12, comprenant en outre :
le fait de calculer le taux d'atténuation de capacité en fonction d'une valeur de condensateur initiale (Cᵢₙᵢₜᵢₐₗ) et de la valeur (C_{now}) de condensateur de courant.

14. Un circuit de calcul (120), comprenant :
un circuit (123) de détection de tension d'entrée, relié à un circuit (110) de conversion de puissance pour détecter une tension (V_{Cin}) de condensateur d'entrée du circuit (110) de conversion de puissance ;
un circuit (125) de détection de tension de sortie, relié au circuit (110) de conversion de puissance pour détecter une tension (V_{Co}) de condensateur de sortie du circuit (110) de conversion de puissance ;
un processeur (121), relié au circuit (123) de détection de tension d'entrée et au circuit (125) de détection de tension de sortie, calculant le temps de maintien du courant en utilisant la tension (V_{Cin}) de condensateur d'entrée et la tension (V_{Co}) de condensateur de sortie, le processeur (121) déclenchant une notification en fonction du temps de maintien du courant ;
un circuit (123) de détection de tension d'entrée, relié au processeur (121) et relié au circuit (110) de conversion de puissance pour détecter une tension (V_{Cin}) de condensateur d'entrée d'un condensateur d'entrée (111) du circuit (110) de conversion de puissance, de sorte que, lorsque le circuit (123) de détection de tension d'entrée détecte que la tension de condensateur d'entrée (V_{Cin}) baisse, il est déterminé qu'une coupure de courant se produit ;
**caractérisé par**
un circuit (122) de détection de courant d'entrée, relié au processeur (121) et relié au circuit (110) de conversion de puissance pour détecter un courant d'entrée (I_{IN}) s'écoulant à travers un interrupteur d'alimentation (114) du circuit de conversion de puissance (110) vers le condensateur d'entrée (111) du circuit (110) de conversion de puissance, de sorte que, lorsque le circuit (122) de détection de courant d'entrée détecte que le courant d'entrée (I_{IN}) passe à 0 par suite de la mise sur arrêt de l'interrupteur d'alimentation (114), il est déterminé qu'une mise hors tension se produit.

15. Le circuit de calcul (120) selon la revendication 14, dans lequel
le circuit de calcul (120) notifie le temps de maintien du courant à un circuit système (10) extérieur à l'alimentation électrique (100) ; ou
le circuit de calcul (120) décide d'envoyer ou non un avertissement pour notifier le circuit système (10) extérieur à l'alimentation électrique (100) en fonction du temps de maintien de courant.

16. Une alimentation électrique (100), comprenant :
un circuit (110) de conversion de puissance, convertissant une tension d'entrée (V_{IN}) en une tension de sortie pour obtenir une puissance de sortie (Po) ; et
un circuit de calcul (120), relié au circuit (110) de conversion de puissance pour mesurer une tension (V_{Cin}) de condensateur d'entrée et une tension (V_{Co}) de condensateur de sortie du circuit (110) de conversion de puissance, le circuit de calcul (120) calculant le temps de maintien de courant du circuit (110) de conversion de puissance en utilisant la tension (V_{Cin}) de condensateur d'entrée et la tension (V_{Co}) de condensateur de sortie, et déclenchant une notification en fonction du temps de maintien de courant ;
le circuit (110) de conversion de puissance comprend un interrupteur d'alimentation (114) et un condensateur d'entrée (111), le circuit de calcul (120) détecte une tension (V_{Cin}) de condensateur d'entrée du condensateur d'entrée (111), le circuit de calcul (120) détermine qu'une mise hors tension se produit lorsque le circuit (123) de détection de tension d'entrée détecte que la tension (V_{Cin}) de condensateur d'entrée baisse,
**caractérisée en ce que** le circuit de calcul (120) détecte un courant d'entrée (I_{IN}) s'écoulant à travers l'interrupteur d'alimentation (114) vers le condensateur d'entrée (111), et le circuit de calcul (120) détermine qu'une mise hors tension se produit lorsque le circuit de calcul (120) détecte que le courant d'entrée (I_{IN}) passe à 0 par suite de la mise sur arrêt de l'interrupteur d'alimentation (114).

17. L'alimentation (100) selon la revendication 16,
dans laquelle le circuit de calcul (120) est le circuit de calcul (120) selon l'une quelconque des revendications 14 à 15.

18. Un procédé de détection de vieillissement de condensateur d'une alimentation (100), comprenant :
le fait de mesurer une tension (V_{Cin}) de condensateur d'entrée et une tension (V_{Co}) de condensateur de sortie d'un circuit (110) de conversion de puissance, le circuit (110) de conversion de puissance comprenant un interrupteur d'alimentation (114) et un condensateur d'entrée (111) ;
le fait de calculer le temps de maintien du courant du circuit (110) de conversion de puissance en utilisant la tension (V_{Cin}) de condensateur d'entrée et la tension (V_{Co}) de condensateur de sortie ;
le fait de déclencher une notification en fonction du temps de maintien du courant ;
le fait de détecter une tension (V_{Cin}) de condensateur d'entrée du condensateur d'entrée (111) ;
le fait de déterminer qu'une mise hors tension se produit lorsque le circuit (123) de détection de tension d'entrée détecte que la tension (V_{Cin}) de condensateur d'entrée baisse ;
**caractérisé par**
le fait de détecter un courant d'entrée (I_{IN}) s'écoulant à travers l'interrupteur d'alimentation (114) vers le condensateur d'entrée (111) ; et
le fait de déterminer qu'une mise hors tension se produit lorsque le courant d'entrée (I_{IN}) est détecté comme passant à 0 par suite de la mise sur arrêt de l'interrupteur d'alimentation (114).

19. Le procédé de détection de vieillissement de condensateur selon la revendication 18, comprenant en outre :
le fait de notifier le temps de maintien du courant à un circuit système (10) extérieur à l'alimentation électrique (100) ; ou
le fait de décider d'envoyer ou non un avertissement pour notifier le circuit système (10) extérieur à l'alimentation électrique (100) en fonction du temps de maintien du courant.
